# EUROPÄISCHE PATENTSCHRIFT

(11) **EP 3 231 595 B1**
(45) Veröffentlichungstag und Bekanntmachung des Hinweises auf die Patenterteilung: **28.09.2022**
(21) Anmeldenummer: 16165227.6
(22) Anmeldetag: 14.04.2016
(51) Int. Cl.: B32B 5/02, B32B 5/26, B32B 7/04, B32B 27/02, B81C 1/00, G06F 1/16, H04R 31/00, B01D 69/10, B01D 69/12, D06M 10/02, B01D 67/00, H04R 7/10, H04R 7/12, H04R 29/00, D04H 1/728, D06M 10/10, D06M 14/18, B01D 39/08, B01D 39/16, D01D 5/00

(54) **KOMPOSIT UND VERFAHREN ZUM HERSTELLEN EINES KOMPOSITS FÜR EINE AKUSTISCHE KOMPONENTE**
COMPOSITE AND METHOD FOR PRODUCING A COMPOSITE FOR AN ACOUSTIC COMPONENT
COMPOSITE ET PROCÉDÉ DE FABRICATION D'UN COMPOSITE POUR UN COMPOSANT ACOUSTIQUE

(43) Veröffentlichungstag der Anmeldung: 18.10.2017
(60) Teilanmeldung: 18154106.1
(73) Patentinhaber: Sefar AG, 9410 Heiden (CH)
(72) Erfinder: HOSSAIN, Mohammad Mokbul, 9410 Heiden (CH); MEIER, Hanspeter, 9112 Schachen (CH); CAMANI, Matteo, 9320 Arbon (CH)
(74) Vertreter: Wunderlich & Heim Patentanwälte Partnerschaftsgesellschaft mbB

(56) Entgegenhaltungen:
- WO-A2-2013/043397
- CN-A- 105 408 010
- US-A1- 2008 220 676
- US-A1- 2010 136 865
- US-A1- 2011 177 741
- US-A1- 2013 197 664
- US-A1- 2014 060 330
- US-A1- 2016 136 584
- Gregory C Rutledge ET AL: "Characterization by mercury porosimetry of nonwoven fiber media with deformation", Journal of Engineered Fibers and Fabrics, 1 January 2009 (2009-01-01), pages 1-13, XP055689258, Retrieved from the Internet: URL:https://dspace.mit.edu/bitstream/handl e/1721.1/69228/jeff-d-09-00010_rev.pdf?seq uence=1 [retrieved on 2020-04-24]
- SEETHA S MANICKAM ET AL: "Characterization of polymeric nonwovens using porosimetry, porometry and X-ray computed tomography", JOURNAL OF MEMBRANE SCIENCE, ELSEVIER BV, NL, vol. 407, 10 March 2012 (2012-03-10), pages 108-115, XP028406738, ISSN: 0376-7388, DOI: 10.1016/J.MEMSCI.2012.03.022 [retrieved on 2012-03-18]

## Beschreibung

Die Erfindung betrifft ein Komposit für eine akustische Komponente gemäß dem Oberbegriff des Anspruchs 1.

Weiterhin betrifft die Erfindung ein Verfahren zum Herstellen eines Komposits für eine akustische Komponente gemäß dem Oberbegriff des Anspruchs 7.

Eine Kompositmembran und ein Verfahren zur Herstellung hierzu gehen aus der US 2011/0177741 A1 hervor. Es wird ein nicht-gewebtes Textil mit einer Trägerschicht und einer Sperrschicht beschrieben, welche beide aus Fasern aufgebaut sind. Die Sperrschicht kann eine Elektro-Spinning-Membran sein.

Aus der US 2008/0220676 A1 geht ein Bekleidungsstück hervor, welches eine Gewebeschicht und eine Schicht aus beschichteten Nanofasern aufweist. Dabei wird zunächst die Schicht aus Nanofasern hergestellt, welche anschließend mit einer Flüssigkeitsbeschichtung versehen wird. Anschließend wird die so beschichtete Faserschicht mit einer Gewebelage verbunden.

Die US 2010/0136865 A1 betrifft ein nicht-gewebtes Gelage aus beschichteten Nanofasern.

Ein Komposittextil für ein Bekleidungsstück mit einer inneren Gewebelage, einer äußeren Gewebelage sowie einer Sperrschicht aus einer nicht-gewebten Membran aus Fasern geht aus der WO 2013/043397 A2 hervor. Die Fasermembran wird mit einer Plasmabeschichtung versehen, bevor diese mit den Gewebelagen verbunden wird.

Die US 2013/0197664 A1 beschreibt ein Filtermedium mit einer Elektro-Spinning-Membran, welche auf eine Stützstruktur aufgebracht ist. Die Stützstruktur kann aus Metall, Keramik, Fieberglas, Graphit oder einem Polymermaterial bestehen. Eine Akustikkomponente mit einer mikroporösen Membran für Elektronikgeräte geht aus der US 2014/0060330 A1 hervor. Die Akustikkomponente weist eine mikroporöse Membranschicht auf, auf welche eine Schicht aus feinen Fasern aufgebracht ist. Die mikroporöse Membranschicht dient dabei als eine Stützschicht.

"Surface Modification of Electrospun PVDF/PAN Nanofibrous Layers by Low Vacuum Plasma Treatment", by F. Yalcinkaya et al. (Int. J. Pol. Sci., Bd. 2016 (01-01-2016), S. 1-6), WO 2010/124899 A1 und JP 2014 030775A beschreiben weitere Aspekte der Offenlegung.

Mit voranschreitender technologischer Entwicklung im Bereich der Wiedergabe von akustischen Signalen besteht ein andauerndes Bedürfnis, die teilweise sensiblen Komponenten vor äußeren Einflüssen zu schützen.

Eine der Herausforderungen hierbei besteht darin, zwar einen Zugang von schädlichen Flüssigkeiten oder nanoskaligen Staub zu den elektronischen Bauteilen einer Akustischen Komponente zu verhindern, jedoch das Klangbild nicht zu verfälschen. Der Erfindung liegt die **Aufgabe** zugrunde, ein Komposit für eine akustische Komponente sowie ein Verfahren zum Herstellen eines Komposits für eine akustische Komponente anzugeben, welche einen hohen Schutz vor Feuchtigkeit, Schweiß, Fett- und/oder Ölen, Staub und Schmutz bei guten akustischer Transparenz mit guter Schalldurchlässigkeit ermöglichen.

Die Aufgabe wird nach der Erfindung zum einen durch ein Komposit für eine akustische Komponente mit den Merkmalen des Anspruchs 1 sowie durch ein Verfahren zum Herstellen eines Komposits für eine akustische Komponente mit den Merkmalen des Anspruchs 6 gelöst. Bevorzugte Ausführungsformen der Erfindung sind in den jeweils abhängigen Ansprüchen angegeben.

Bei dem erfindungsgemäßen Komposit für eine akustische Komponente ist u.a. vorgesehen, dass das Komposit mindestens eine Trägerschicht und eine Elektro-Spinning-Membran aufweist, welche auf der mindestens einen Trägerschicht angeordnet ist, wobei die Elektro-Spinning-Membran aus übereinanderliegenden Fasern unter Ausbildung einer Porenstruktur gebildet ist, wobei die Porenstruktur ausgebildet ist, dass das Komposit eine Wassersäule von mindestens 1 m und Luftdurchlässigkeit von 5 L/m²*s aufweist. Die Fasern sind als Nanofasern oder Mikrofasern zum Bilden einer Nanostruktur beziehungsweise Mikrostruktur ausgebildet. Die Fasern bilden ein dreidimensionales nicht-gewebtes Netzwerk. Ein solches Komposit erfüllt auch besonders strenge Schutzklassenanforderungen. Die Luftdurchlässigkeit bestimmt sich nach der ISO 9237:1995-12 Norm und die Wassersäule nach der ISO 811:1981 Norm.

Weiterhin ist das erfindungsgemäße Verfahren zum Herstellen eines Komposits für eine akustische Komponente dadurch u.a. gekennzeichnet, dass eine Trägerschicht vorgesehen wird und auf der Trägerschicht nach dem Elektro-Spinning-Verfahren eine Membran ausgebildet wird, wobei die Membran aus übereinanderliegenden Fasern mit einer definierten Porenstruktur hergestellt wird. Die definierte Porenstruktur betrifft insbesondere eine definierte Porengröße und eine definierte Porenverteilung. Dies kann insbesondere für eine hohe Porosität des Komposits vorteilhaft sein.

Ein Grundgedanke der Erfindung liegt darin, ein Komposit bereitzustellen, wobei das Komposit mit einer hohen Porosität gebildet ist, welche den Durchtritt von Gasen, insbesondere von Luft, ermöglicht, wohingegen Flüssigkeiten durch das Komposit zurückgehalten werden.

Die Membran des erfindungsgemäßen Komposits, welche nach dem Elektro-Spinning-Verfahren hergestellt ist, unterscheidet sich von anderen (Polymer-) Membranen insbesondere durch einen vielschichtigen netz-, dreidimensional vernetzten nest- beziehungsweise gitterartigen Aufbau mit einer hohen spezifischen Oberfläche, also einem hohen Oberfläche zu Volumen Verhältnis. Herkömmliche Membranen, welche für wasserabweisende Anwendungen zum Einsatz kommen, beispielsweise Polytetrafluoroethylen (PTFE - Gore-Tex^{®}), expandiertes Polytetrafluoroethylen (ePTFE) und auch klassische Membranen, weisen eine laminare, dichte Filmstruktur auf. Diese Membranen sind strukturbedingt für Luft quasi undurchlässig (0 L/m²*s). Die bekannte "atmungsaktive" Eigenschaft von Filmmembranen, insbesondere PTFE-Membranen, ist gerade nicht auf eine Porenstruktur sondern vielmehr eine direkte Wechselwirkung des Membranmaterials mit Wasserdampf zurückzuführen.

Weiterhin können insbesondere die PTFE und ePTFE Membranen schädliche Rohstoffrückstände und Spuren von langkettigen Perfluoralkylsäuren wie Perfluoroctansäure (PFOA) enthalten. Erfindungsgemäß ist das Komposit frei von Chlor und Brom. Insbesondere ist das erfindungsgemäße Komposit gemäß IEC 61249-2-21 (Brom <900 ppm, Chlor <900 ppm, gesamter Halogenanteil <1500 ppm), IPC 4101B (Brom <900 ppm, Chlor <900 ppm, gesamter Halogenanteil <1500 ppm) und JPCA ES-01-1999 (Brom <900 ppm, Chlor <900 ppm) frei von Halogenen und umweltschädlichen Verbindungen wie PFOA/PFOS (Perfluoroctansulfonsäure)

Erfindungsgemäß ist die Fähigkeit des Komposits, Wasser zurückzuhalten, mit der Einheit "Wassersäule" definiert. "Wassersäule" ist eine Einheit zur Messung des Drucks auf eine Oberfläche, wie beispielsweise eine Gewebeanordnung oder ein Komposit. Ein Druck von 1 m Wassersäule ist definiert als derjenige Druck, der dem hydrostatischen Druck in 1 m Wassertiefe entspricht. Vorliegend beziehen sich die Angaben der Wassersäule auf einen hydrostatischen Druck bei 20°C Wassertemperatur, insbesondere gemäß ISO 811:1981.

Nach der Erfindung ist eine bestimmte Wassersäule des erfindungsgemäßen Komposits gegeben (beispielsweise 5 m), wenn das Komposit bei einem entsprechenden einseitig auf das Komposit wirkenden hydrostatischen Druck keine nennenswerte Durchlässigkeit für Wasser zeigt. Die jeweils angegebene Wassersäule ist demnach ein Maß für die Dichtigkeit des erfindungsgemäßen Komposits gegenüber Wasser.

Vorzugsweise weist das erfindungsgemäße Komposit eine Wassersäule von 5 m, bevorzugt von 10 m, besonders bevorzugt von 35 m auf.

Die nach der Erfindung beanspruchte Luftdurchlässigkeit des Komposits beruht auf einer Differenzdruckmessung bei 20°C und 65 % relative Luftfeuchtigkeit. Der einseitig an dem Komposit angelegte erhöhte Druck beträgt bei der Messung 200 Pa (Pascal) und die Prüffläche beträgt 20 cm² des Komposits, insbesondere gemäß ISO 9237:1995-12.

Das unter diesen Bedingungen durch das Komposit durchtretende Luftvolumen entspricht 1/500 des Volumenstroms, welcher in 1 Sekunde durch 1 m² des Komposits durchtritt (L/m²*s). Der Volumenstrom an Luft, welcher durch 1 m² des Komposits in 1 Sekunde durchtritt, ist die erfindungsgemäß beanspruchte Luftdurchlässigkeit.

Vorzugsweise beträgt die Luftdurchlässigkeit des Komposits 10 L/m²*s, bevorzugt 30 L/m²*s, besonders bevorzugt 50 L/m²*s.

Eine bevorzugte Ausführungsform des erfindungsgemäßen Komposits besteht darin, dass das Komposit mit einer Plasmabeschichtung nach dem PECVD-Verfahren versehen ist. Vorzugsweise ist die Plasmabeschichtung so ausgebildet, dass sie die Eigenschaften des Komposits ergänzt, insbesondere einen Abperleffekt (sogenannter Lotuseffekt), eine antistatische Wirkung und/oder eine Antihaftbeschichtung bereitstellt. Zumindest kann das vernetzte Plasmapolymer, also die Plasmabeschichtung jedoch zu den öl-, fett- und/oder wasserabweisenden Eigenschaften des Komposits beitragen. Vorzugsweise weist das Komposit, insbesondere die Plasmabeschichtung eine niedrige Oberflächenenergie mit einem Wasser-Kontaktwinkel von mindestens 120°, besonders bevorzugt mit einem Wasser-Kontaktwinkel von 140° oder mehr auf, gemäß Messung nach DIN 55660-2:2011-12.

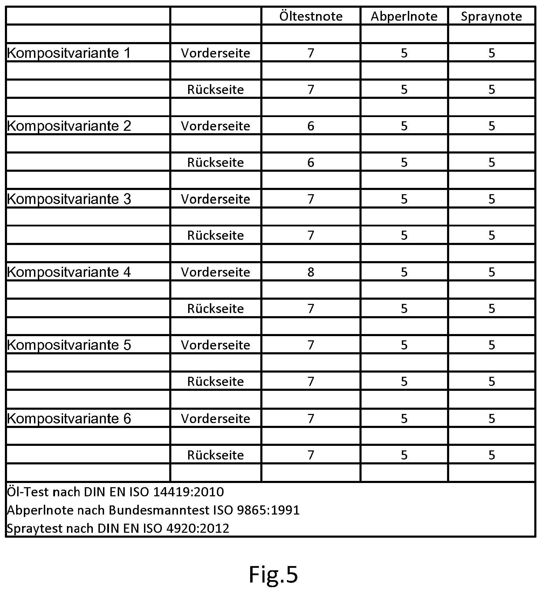

Ausführungsvarianten des erfindungsgemäßen Komposits wurden dem Öltropfentest gemäß DIN EN ISO 14419:2010 unterzogen. Wie Figur 5 zu entnehmen ist, weisen alle Ausführungsformen eine gute (6) bis sehr gute (8) Note auf. Bei (Wasser-) Spraytests gemäß DIN EN ISO 4920:2012 und der Bestimmung des Abperleffekts nach Bundesmanntest gemäß ISO 9865:1991 konnten alle Ausführungsformen des erfindungsgemäßen Komposits die Bestnote (5 von 5) erreichen.

Die plasmaunterstützte chemische Gasphasenabscheidung (PECVD) ist eine Methode zur Beschichtung von Oberflächen, bei welcher die chemische Abscheidung eines Beschichtungssubstrats durch ein Plasma unterstützt wird. Das Plasma kann direkt beim zu beschichtenden Substrat (Direktplasma-Methode) oder in einer getrennten Kammer (Remote-Plasma-Methode) generiert werden. Beispielsweise auf Grund beschleunigter Elektronen wird eine Dissoziation von Molekülen des Reaktionsgases zu reaktiven Plasmateilchen, beispielsweise Radikalen und Ionen erzeugt (Plasma), die die Schichtabscheidung auf dem Substrat bewirken können. So kann eine Oberflächenbeschichtung bereitgestellt werden, welche gegenüber herkömmlichen nasschemischen Polymerisationsverfahren eine hochvernetzte Polymerstruktur bereitstellt, die Poren einer beschichteten Membran jedoch nicht verschließt.

Die erfindungsgemäße Trägerschicht ist ein Gewebe, nämlich ein Monofilament, wobei sie insbesondere eine stützende und/oder schützende Funktion in Bezug auf die Membran einnimmt. Vorzugsweise ist die Trägerschicht mit geringer akustischer Impedanz, wasser-, öl-, fett- und/oder staubabweisenden Eigenschaften gebildet. Eine präzise Auswahl der Trägerschicht insbesondere seiner Garnfeinheit, Geometrie, Oberflächenbeschaffenheit sowie dem Anteil offener Flächen kann erheblichen Einfluss auf die endgültige Komposit-Funktion haben. Je höher die Luftdurchlässigkeit eines Mediums, desto geringer ist seine akustische Impedanz und desto höher ist sein Schalldurchlass. Das Gewebe weist vorzugsweise einen Durchmesser des Filaments oder Garns von 10 µm bis 400 µm und eine Maschenöffnung von bis zu 300 µm auf. Das erfindungsgemäße Komposit ist hinsichtlich seiner akustischen Eigenschaften und seiner Schutzeigenschaften besonders ausgewogen. Es können maßgeschneiderte Komposite hinsichtlich einer definierten Porosität und einer definierten Dichte an plasmafunktionellen Gruppen geschaffen werden.

Es ist erfindungsgemäß, dass die Plasmabeschichtung sowohl auf der Elektro-Spinning-Membran als auch auf der mindestens einen Trägerschicht ausgebildet ist. Somit ist ein flexibler Einsatz des Komposits gewährleistet, wobei die öl-, fett- und/oder wasserabweisende Eigenschaft des Komposits unabhängig davon gewährleistet werden kann, ob die Trägerschicht der akustischen Komponente zugewandt oder abgewandt angeordnet ist. Besonders bevorzugt ist es hierbei, dass die Plasmateilchen in die Poren des Komposits eindringen und die Fasern individuell mir der Beschichtung umhüllen beziehungsweise ummanteln. Während der Plasmapolymerisation kann auf die Dichte der funktionellen Gruppen und die Art des Plasmapolymers Einfluss genommen werden.

Besonders bevorzugt ist es nach einer Weiterbildung der Erfindung, dass die Plasmabeschichtung aus einem Material mit hydrophober und/oder oleophober Eigenschaft gebildet ist. Die Plasmabeschichtung kann zu einer Verstärkung der öl-, fett- und/oder wasserabweisenden Eigenschaften des Komposits, insbesondere den Eigenschaften der Elektro-Spinning-Membran, beitragen.

Eine bevorzugte Weiterbildung des erfindungsgemäßen Komposits besteht darin, dass das Material zumindest gesättigte einfach und/oder mehrfach ungesättigte, Ether, Ketone, Aldehyde, Alkene, Alkine, Amide, Amine, Nitrile, Thioether, Carbonsäureesther, Thioesther, Sulfone, Thioketone, Thioaldyhyde, Sulfene, Sulfenamide, Fluoroacrylate, Siloxane, Epoxide, Urethane und/oder Acrylate umfasst. Besonders bevorzugt sind Materialien, die bei einer Anwendung eines Plasmabeschichtungsverfahrens Radikale oder Ionen freigeben, welche zu einer unpolaren teflonähnlichen Oberfläche auf dem Komposit beitragen.

Die Trägerschicht ist mit der Membran fest verbunden. Dies beugt einem Delaminieren und/oder einer Relativverschiebung der Schichten vor. Die Trägerschicht kann mit der Membran sowohl in einem Randbereich des Komposits umfangsseitig durchgehend oder punktuell als auch in einem innenliegenden Bereich des Komposits linien- oder punktförmig verbunden sein.

Zum Bilden eines besonders robusten Komposits ist es nach der Erfindung vorteilhaft, dass die Membran zwischen zwei Trägerschichten angeordnet ist. Es können also mindestens drei Schichten vorgesehen sein. Die Membran kann hierbei beidseitig von Trägerschichten zumindest teilweise überdeckt sein. Die mindestens zwei Trägerschichten können bedarfsgerecht dieselben (Sandwich-Anordung) oder unterschiedliche Eigenschaften (Hybrid-Anordnung) aufweisen, die sich in ihrer Wirkungsweise gegenseitig ergänzen können. So kann eine erste Trägerschicht beispielsweise mit einer hydrophoben, also öl-, fett- und/oder wasserabweisenden Eigenschaft ausgebildet sein, wobei die zweite Trägerschicht insbesondere Staub abweisend, beispielsweise anti-statisch ausgebildet sein kann. Besonders bevorzugt ist es, dass mehrere Trägerschichten und mehrere Membranen in dem Komposit, je nach anwendungsspezifischen funktionellen Anforderungen, alternierend angeordnet sind. Die einzelnen Trägerschichten und Membranen können beispielsweise mit unterschiedlicher Porosität, Porenverteilung, Hydrophobizität, Oleophobizität sowie unterschiedlicher Staub abweisender Eigenschaft ausgebildet sein. Nach einer besonders zweckmäßigen Weiterbildung des erfindungsgemäßen Komposits ist es vorteilhaft, dass die Membran mit einem durchschnittlichen Porendurchmesser von 0,08 µm bis 100 µm gebildet ist. Der durchschnittliche Porendurchmesser ist bereits bei der Herstellung der Membran nach dem Elektro-Spinning-Verfahren einstellbar und kann bedarfsgerecht an die Erfordernisse des Komposits angepasst werden. Vorzugsweise weicht der Porendurchmesser einzelner Poren von dem durchschnittlichen Porendurchmesser um nicht mehr als 500 %, bevorzugt nicht mehr als 300 %, besonders bevorzugt nicht mehr als 100 % ab. Vorzugsweise sind die Fasern von Membranen mit einem Durchmesser von 40 nm bis 500 nm, besonders bevorzugt mit 80 nm bis 250 nm gebildet. Die Durchmesser einzelner Fasern einer Membran weisen vorzugsweise ähnliche Durchmesser auf. Insbesondere unterscheidet sich der Durchmesser einzelner Fasern von einem mittleren Faserdurchmesser um weniger als 500 %, bevorzugt 300 %, besonders bevorzugt von weniger als 100 %.

Die erfindungsgemäße Membran kann in der Medizintechnik, in akustischen Vents, in Bau- und Elektronikabdichtungen oder in Gesichtsmasken eingesetzt werden. Die individuell einstellbare Porosität des erfindungsgemäßen Komposits kann beispielsweise vorteilhaft zu einer Abscheidung von Festkörpern in einem Gasstrom beitragen oder eine atmungsaktive Auflage bereitstellen.

Ein Grundgedanke des erfindungsgemäßen Verfahrens besteht darin, eine Elektro-Spinning-Membran auf einer Trägerschicht auszubilden. Die Membran kann hierbei mit einer definierten Porosität, also zumindest mit definierter Porengröße und/oder Porenverteilung, gebildet werden, wobei eine Dichte an membranbildenden Fasern eingestellt wird. Das anteilige Raumvolumen der Fasern als auch die durchschnittliche Anzahl an Fasern in einem betrachteten Volumen der Membran können eingestellt werden. Die Trägerschicht kann hierbei insbesondere als stabilisierende und/oder schützende Auflage für die Membran dienen.

Für eine besonders zuverlässige Koppelung und Einbettung der einzelnen Kompositschichten kann es nach der Erfindung vorteilhaft sein, dass die Membran mit der Trägerschicht mittels eines Heiß-Schmelz-Verfahrens, insbesondere mittels eines Lasers, durch Ultraschallschweißen, durch Laminieren, durch Kleben, durch Plasmabehandlung oder einer Kombination hiervon fest verbunden wird. Das Kleben kann insbesondere mit einem Epoxid-, Acrylat und/oder Polyurethankleber durchgeführt werden. Ein Delaminieren kann so zuverlässig verhindert werden. Besonders bevorzugt ist es, dass die Verbindestellen zwischen Trägerschicht und Membran punktuell oder linienförmig vorgesehen werden und gleichmäßig über das Komposit verteilt werden, was einen nur geringen Verlust an Porosität beziehungsweise Luftdurchlässigkeit begünstigen kann.

Für ein besonders effizientes Herstellungsverfahren des erfindungsgemäßen Komposits kann es nach einer Weiterbildung vorteilhaft sein, dass die Elektro-Spinning-Membran direkt auf der Trägerschicht hergestellt wird, wobei sich die Membran fest mit der Trägerschicht verbindet. Grundsätzlich besteht die Möglichkeit, die Membran auf einer ersten Trägerschicht, beispielsweise einem Trägervlies oder einem Trägergewebe, nach dem Elektro-Spinning-Verfahren herzustellen und diese in einem zweiten Schritt auf die erfindungsgemäße Trägerschicht, beispielsweise ein Gewebe, durch ein Delaminations-Laminations-Verfahren zu übertragen. Das direkte Vorsehen der Membran auf der erfindungsgemäßen Trägerschicht kann aufwändigen Übertragungsvorgängen der Membran vorbeugen. Weiterhin kann die Oberfläche der Trägerschicht chemisch und/oder morphologisch modifiziert werden, wodurch die Membran beim Ausbilden besonders positionsfest an der Trägerschicht anhaften kann.

Die Membran kann mit einer Schichtdicke von weniger als 100 µm, insbesondere weniger als 50 µm, bevorzugt mit einer Schichtdicke von 1 bis 10 µm, bereitgestellt werden. Erfindungsgemäß kann bereits eine Membran mit diesen geringen Schichtdicken zu der erfindungsgemäßen Wassersäule und Luftdurchlässigkeit beitragen.

Nach einer Weiterbildung des erfindungsgemäßen Verfahrens ist es vorgesehen, dass mindestens eine weitere Trägerschicht vorgesehen wird, welche ebenfalls mit der Membran verbunden wird, wobei die Membran zwischen den Trägerschichten angeordnet wird. Zum Schutz der Membran beispielsweise vor mechanischen Einflüssen in aggressiver Umgebung kann diese beidseitig mit jeweils einer Trägerschicht versehen werden. Bei einem vielschichtigen Aufbau, einem sogenannten Multilayer-Aufbau, kann das Komposit mit jeweils mindestens zwei Trägerschichten und mindestens zwei Membranschichten ausgebildet werden, wobei die Membranschichten übereinanderliegend angeordnet sind. Vorzugsweise ist mindestens eine Trägerschicht zwischen der ersten Membran und der mindestens zweiten Membran angeordnet.

Besonders bevorzugt ist es nach dem erfindungsgemäßen Verfahren, dass das Komposit nach einem Plasmabeschichtungsverfahren mit einer Oberflächenbeschichtung versehen wird, wobei eine Einführung spezieller funktioneller Gruppen auf der Oberfläche des Komposits oder die Modifizierung der Oberfläche des Komposits ermöglicht wird. Mittels der Nanobeschichtung können die öl-, fett-, schmutz- und/oder wasserabweisende Eigenschaften des Komposits besonders vorteilhaft beeinflusst werden, wobei die Porosität und/oder die Luftdurchlässigkeit der beschichteten Membran im Wesentlichen mit der im unbeschichteten Zustand übereinstimmt. Mittels der Plasmabeschichtung wird ein dünner Film mit spezifischer Oberflächenfunktion (insbesondere hydro- und/oder oleophob) auf der Oberfläche des Komposits, insbesondere den einzelnen Fasern der Membran und/oder den einzelnen Fasern oder Filamenten der Trägerschichten, aufgetragen. Hierbei können besonders dünne Schichtdicken von wenigen nm (Nanometer), insbesondere von weniger als 80 nm, bevorzugt von 5 nm bis 40 nm erreicht werden. Diese ultra-dünnen Plasmaschichten sind im Verhältnis zum Porendurchmesser vernachlässigbar klein. Daher wird der Porendurchmesser einer erfindungsgemäßen Membran durch eine Beschichtung nach einer plasmagestützten Gasphasenabscheidung, wie beispielsweise dem PECVD-Verfahren, dem Grunde nach nicht verändert.

Diese Plasmapolymere können eingebettete Fluor-haltige und/oder Fluor-freie funktionelle Gruppen aufweisen, welche gegenüber klassischen Fluorcarbonen frei von langkettigen Perfluoralkylsäuren, wie Perfluoroctansäure (PFOA) oder Perfluoroctansulfonsäure (PFOS) als Verunreinigung sind, welche bereits weltweit als Bedrohung für die Umwelt identifiziert wurden.

Die Erfindung wird nachfolgend anhand eines bevorzugten Ausführungsbeispiels weiter beschrieben, welches schematisch in den beigefügten Zeichnungen dargestellt ist. In den Zeichnungen zeigen:
- Fig. 1: zeigt eine schematische Querschnittsdarstellung eines erfindungsgemäßen Komposits in seiner einfachsten Ausführungsform ("Single layer");
- Fig. 2: zeigt eine schematische Querschnittsdarstellung des erfindungsgemäßen Komposits in der sogenannten "Sandwich"-Anordnung;
- Fig. 3: zeigt eine schematische Querschnittsdarstellung des erfindungsgemäßen Komposits mit einem mehrlagigen Aufbau ("Multi layer");
- Fig. 4: zeigt eine schematische Querschnittsdarstellung des erfindungsgemäßen Komposits in einer "Hybrid"-Anordnung mit zwei unterschiedlichen Trägerschichten; und
- Fig. 5: zeigt tabellarisch das Ergebnis mehrerer Tests an erfindungsgemäßen Kompositen.

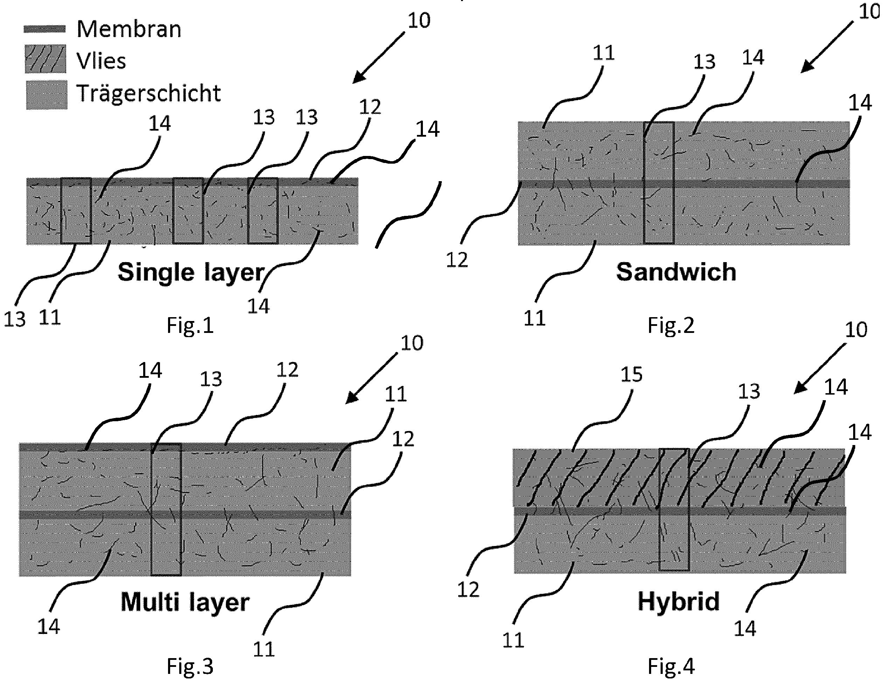

Fig. 1 zeigt eine Querschnittsansicht des erfindungsgemäßen Komposits 10 mit einer Trägerschicht 11. Auf der Trägerschicht 11 ist eine Membran 12 angeordnet, welche nach dem Elektro-Spinning-Verfahren gebildet und auf der Trägerschicht 11 aufgebracht ist. Für ein verbessertes Anhaften der Membran 12 auf der Trägerschicht 11 kann das Komposit mit mindestens einem Verbindepunkt 13 ausgebildet sein, welcher die beiden Schichten miteinander fest verbindet. Hierbei kann es sich insbesondere um eine Schmelz- oder Klebestelle in Form von Punkten oder Linien handeln. Aufgrund der geringen Schichtdicken des Trägermaterials 11 sowie der Membran 12 kann das Komposit an der Verbindestelle durch den Verbindepunkt 13 vollständig durchdrungen sein.

Das Komposit 10, insbesondere die Elektro-Spinning-Membran 12 kann mit einer Porosität gebildet sein. Die Oberfläche des Komposits 10 sowie die Fasern der Poren können mit einer Beschichtung, welche insbesondere nach dem Plasmabeschichtungsverfahren aufgetragen ist, beschichtet sein. Die Oberflächenbeschichtung der Fasern ist in den Figuren schematisch durch die eingezeichneten Punkte
und Linien 14 dargestellt. Erfindungsgemäß kann das Komposit 10 vollständig mit dem Plasmapolymer oberflächenbeschichtet sein. Dies kann ebenfalls Fasern der in einem innenliegenden beziehungsweise tiefer im Komposit 10 liegenden Bereich in den Poren der Membran 12 umfassen. Es kann also nicht nur die makroskopische äußere Oberfläche des Komposits beschichtet sein, sondern auch die mikroskopische innenliegende Oberfläche, also beispielsweise Fasern, Vertiefungen und Unebenheiten, wobei die einzelnen Fasern individuell umhüllt beziehungsweise ummantelt werden.

Fig. 2 zeigt das erfindungsgemäße Komposit 10 in einer sogenannten "Sandwich"-Anordnung. In dieser ist die Membran 12 zwischen zwei Trägerschichten 11 angeordnet, wodurch die Membran 12 insbesondere gegenüber mechanischer Beanspruchung zwischen den Schichten geschützt vorliegt. In einer Ausführungsform der Sandwichanordnung konnte beispielsweise eine Luftdurchlässigkeit von 15,6 L/m²*s erreicht werden. Grundsätzlich kann auch bei der Sandwich-, Multilayer oder Hybridanordnung eine Luftdurchlässigkeit von bis zu 50 L/m²*s erreicht werden.

In jeder möglichen Anordnung von Schichten in einem Komposit 10 können diese durch einfaches Laminieren aufeinander angeordnet sein. Die Schichten können jedoch ebenfalls über Verbindepunkte 13 miteinander fest verbunden sein, wodurch eine besonders zuverlässige mechanische Belastbarkeit des Komposits 10 erreicht werden kann.

In Fig. 3 ist eine mehrschichtige Anordnung des Komposits 10 (Multi layer) dargestellt. Bei dieser Anordnung sind alternierend Trägerschichten 11 und Membranschichten 12 übereinander gelagert vorgesehen. Nach Fig. 3 sind zwei Trägerschichten 11 und zwei Membranschichten 12 vorgesehen. Eine vielschichtige Anordnung kann jedoch auch eine beliebige Anzahl von Trägerschichten 11 und/oder Membranschichten 12 aufweisen. Ebenfalls ist es möglich, zwei Membranschichten 12 direkt übereinander zwischen zwei oder mehreren Trägerschichten bedarfsgerecht vorzusehen. Auch bei einer vielschichtigen Anordnung kann die Plasmabeschichtung auf der mikroskopischen Oberfläche aller übereinander gelagerten Membranschichten 12 und Trägerschichten 11 vorgesehen werden. Demnach ist die Plasmabeschichtung auch bei mehrschichtigem Aufbau auf innenliegenden Oberflächen des Komposits 10 vorsehbar.

Fig. 4 zeigt eine Ausführungsvariante des erfindungsgemäßen Komposits 10, bei welchem die Membran 12 zwischen einer ersten Trägerschicht 11 und einer zweiten Trägerschicht 15 angeordnet ist. Grundsätzlich kann die erste Trägerschicht 11 insbesondere als Gewebe ausgebildet sein, wohingegen die zweite Trägerschicht 15 sich von der ersten Trägerschicht 11 unterscheidet und insbesondere als Vlies bereitgestellt werden kann. Mit einer solchen "Hybrid"-Anordnung können Eigenschaften verschiedener Materialien vorteilhaft in dem Komposit verbunden werden, wodurch in vorteilhafter Weise Filter-, Schutz- und akustische Transmissionseigenschaften in dem Komposit 10 verwirklicht werden können. Auch bei einer Hybrid-Anordnung wie in Fig. 4 gezeigt, kann eine Plasmabeschichtung auf der gesamten Oberfläche des Komposits 10 vorgesehen werden, wobei die Plasmapolymerisation ebenfalls innerhalb des Komposits 10 in tiefer liegenden Schichten beispielsweise innerhalb von Porenöffnungen stattfinden kann.

Ebenfalls ist es denkbar, einen Multilayer-Aufbau des Komposits 10 mit unterschiedlichen Trägerschichten 11, 15 und unterschiedlich ausgebildeten Membranen 12 vorzusehen.

Fig. 5 zeigt tabellarisch das Ergebnis des sogenannten "Öltropfentests" gemäß DIN EN ISO 14419:2010, Bundesmanntest gemäß ISO 9865:1991 und des (Wasser-) Spraytests gemäß DIN EN ISO 4920:2012 an erfindungsgemäßen Kompositen.

Bei dem "Öltropfentests" wird die Oleophobizität einer Oberfläche anhand der Form eines Öltropfens auf der zu prüfenden Oberfläche bestimmt, wobei standardisierte Öle (1 bis 8; Fig. 5) eingesetzt werden. Besonders oleophobe Oberflächen zeigen nicht nur mit den Ölen 1 bis 5 sondern auch mit den Ölen 6, 7 und 8 ein besonders abweisendes Verhalten, wodurch der Öltropfen jeweils als Perle auf der Oberfläche vorliegt. Das Bestergebnis wird bei diesem Test durch die Note 8 dargestellt, was einer Perlenbildung bei allen 8 verwendeten Ölen entspricht. Nach Fig. 5 weisen alle erfindungsgemäßen Ausführungsformen gute (Note 6) bis sehr gute (Note 8) oleophobe Eigenschaften auf.

Erfindungsgemäße Komposite erreichen beim Bundesmanntest sowie beim Spraytest die Bestnote (5 von 5; Fig. 5).

## Patentansprüche

1. Komposit für eine akustische Komponente mit
- mindestens einer Trägerschicht (11, 15) und
- einer Elektro-Spinning-Membran (12), welche auf der mindestens einen Trägerschicht (11, 15) angeordnet ist, wobei die Elektro-Spinning-Membran (12) aus übereinander liegenden Fasern unter Ausbildung einer Porenstruktur gebildet ist,
wobei die Porenstruktur ausgebildet ist, dass
- das Komposit (10) eine Wassersäule von mindestens 1 m gemäß ISO 811: 1981 und eine Luftdurchlässigkeit von mindestens 5 L/m²*s gemäß ISO 9237: 1995-12 aufweist,
- das Komposit (10) mit einer Plasmabeschichtung (14) versehen ist, und
- wobei die Trägerschicht (11, 15) und die Elektro-Spinning-Membran (12) fest mit einander verbunden sind,
- wobei als Trägerschicht (11, 15) ein Monofilament-Gewebe vorgesehen ist und die Plasmabeschichtung (14) sowohl auf der Elektro-Spinning-Membran (12) als auch auf der mindestens einen Trägerschicht (11, 15) ausgebildet ist.

2. Komposit nach Anspruch 1,
**dadurch gekennzeichnet,**
**dass** das Komposit (10) mit einer Plasmabeschichtung (14) nach dem PECVD-Verfahren versehen ist.

3. Komposit nach einem der Ansprüche 1 oder 2,
**dadurch gekennzeichnet,**
**dass** die Plasmabeschichtung (14) aus einen Material mit hydrophober und/oder oleophober Eigenschaft gebildet ist.

4. Komposit nach Anspruch 3,
**dadurch gekennzeichnet,**
**dass** das Material zumindest gesättigte, einfach und/oder mehrfach ungesättigte Ether, Ketone, Aldehyde, Alkene, Alkine, Amide, Amine, Nitrile, Thioether, Carbonsäureesther, Thioesther, Sulfone, Thioketone, Thioaldyhyde, Sulfene, Sulfenamide, Fluoroacrylate, Siloxane, Epoxide, Urethane und/oder Acrylate umfasst.

5. Komposit nach einem der Ansprüche 1 bis 4,
**dadurch gekennzeichnet,**
**dass** die Membran (12) zwischen zwei Trägerschichten (11, 15) angeordnet ist.

6. Verfahren zum Herstellen eines Komposits für eine akustische Komponente, nach einem der Ansprüche 1 bis 5, bei welchem
- eine Trägerschicht (11, 15) vorgesehen wird,
- auf der Trägerschicht (11, 15) eine Membran (12) ausgebildet wird, wobei die Membran (12) nach dem Elektro-Spinning-Verfahren aus übereinander liegenden Fasern mit einer definierten Porenstruktur hergestellt wird,
- wobei die Trägerschicht (11, 15) und die Membran (12) fest miteinander verbunden werden,
**dadurch gekennzeichnet,**
- **dass** ein Monofilament-Gewebe als die Trägerschicht (11, 15) vorgesehen wird, und
- **dass** das Komposit (10) nach einem Plasmabeschichtungsverfahren mit einer Oberflächenbeschichtung (14) versehen wird, wobei die Plasmabeschichtung (14) sowohl auf die Elektro-Spinning-Membran (12) als auch auf die mindestens eine Trägerschicht (11, 15) aufgebracht wird.

7. Verfahren zum Herstellen eines Komposits nach Anspruch 6,
**dadurch gekennzeichnet,**
**dass** die Membran (12) mit der Trägerschicht (11, 15) mittels eines Heiß-Schmelz-Verfahrens, insbesondere mittels eines Lasers, durch Ultraschallschweißen, durch Laminieren, durch Kleben durch Plasmabehandlung oder einer Kombination hiervon, fest verbunden wird.

8. Verfahren nach einem der Ansprüche 6 oder 7,
**dadurch gekennzeichnet,**
**dass** die Elektro-Spinning-Membran (12) direkt auf der Trägerschicht (11, 15) hergestellt wird, wobei sich die Membran (12) fest mit der Trägerschicht (11, 15) verbindet.

9. Verfahren nach einem der Ansprüche 6 bis 8,
**dadurch gekennzeichnet,**
**dass** mindestens eine weitere Trägerschicht (11, 15) vorgesehen wird, welche ebenfalls mit der Membran (12) verbunden wird, wobei die Membran (12) zwischen den Trägerschichten (11, 15) angeordnet wird.

## Claims

1. Composite for an acoustic component having
- at least one carrier layer (11, 15) and
- an electrospun membrane (12) which is arranged on the at least one carrier layer (11, 15), wherein the electrospun membrane (12) is formed of superimposed fibers with the formation of a pore structure,
wherein the pore structure is designed that
- the composite (10) has a water column of at least 1 m according to ISO 811:1981 and an air permeability of at least 5 L/m²*s according to ISO 9237:1995-12,
- the composite (10) is provided with a plasma coating (14), and
- wherein the carrier layer (11, 15) and the electrospun membrane (12) are firmly joined with each other,
- wherein as carrier layer (11, 15) a monofilament fabric is provided and
the plasma coating (14) is formedboth on the electrospun membrane (12) and on the at least one carrier layer (11, 15).

2. Composite according to claim 1,
**characterized in that**
the composite (10) is provided with a plasma coating (14) according to the PECVD method.

3. Composite according to claim 1 or 2,
**characterized in that**
the plasma coating (14) is formed of a material with hydrophobic and/or oleophobic property.

4. Composite according to claim 3,
**characterized in that**
the material comprises at least saturated, monounsaturated and/or polyunsaturated ethers, ketones, aldehydes, alkenes, alkynes, amides, amines, nitriles, thioethers, carboxylic acid esters, thioesters, sulfones, thioketones, thioaldehydes, sulfenes, sulfenamides, fluoroacrylates, siloxanes, epoxides, urethanes and/or acrylates.

5. Composite according to any one of claims 1 to 4,
**characterized in that**
the membrane (12) is arranged between two carrier layers (11, 15).

6. Method for producing a composite for an acoustic component according to any one of claims 1 to 5, in which
- a carrier layer (11, 15) is provided and
- on the carrier layer (11, 15) a membrane (12) is formed, wherein the membrane (12) is produced according to the electrospinning method of superimposed fibers with a defined pore structure,
- wherein the carrier layer (11, 15) and the membrane (12) are firmly joined with each other,
**characterized in that**
- a monofilament fabric is provided as the carrier layer (11, 15) and
- **in that** the composite (10) is provided with a surface coating (14) using a plasma coating method,
wherein the plasma coating (14) is applied both to the electrospun membrane (12) and to the at least one carrier layer (11, 15) .

7. Method of producing a composite according to claim 6,
**characterized in that**
the membrane (12) is firmly joined to the carrier layer (11, 15) by means of a hot melt method, in particular by means of a laser, by ultrasonic welding, by laminating, by adhesive bonding, by plasma treatment or a combination thereof.

8. Method according to any one of the claims 6 or 7,
**characterized in that**
the electrospun membrane (12) is produced directly on the carrier layer (11, 15), wherein the membrane (12) becomes firmly joined to the carrier layer (11, 15).

9. Method according to any one of claims 6 to 8,
**characterized in that**
at least one further carrier layer (11, 15) is provided which is also joined to the membrane (12), wherein the membrane (12) is arranged between the carrier layers (11, 15).

## Revendications

1. Composite pour un composant acoustique avec
- au moins une couche de support (11, 15) et
- une membrane électro-filée (12) qui est disposée sur l'au moins une couche de support (11, 15), la membrane électro-filée (12) étant formée de fibres superposées pour constituer une structure poreuse,
dans lequel la structure poreuse est constituée de sorte que
- le composite (10) présente une colonne d'eau d'au moins 1 m selon ISO 811: 1981 et une perméabilité à l'air d'au moins 5 I/m²*s selon ISO 0237:1995-12,
- le composite (10) est doté d'un revêtement de plasma (14),
- la couche de support (11, 15) et la membrane électro-filée (12) étant reliées de façon fixe entre elles et
- un tissu en monofilament étant prévu comme couche de support (11, 15) et le revêtement de plasma (14) étant formé aussi bien sur la membrane électro-filée (12) que sur l'au moins une couche de support (11, 15).

2. Composite selon la revendication 1,
**caractérisé**
**en ce que** le composite (10) est doté d'un revêtement de plasma (14) selon le procédé PECVD.

3. Composite selon une des revendications 1 ou 2,
**caractérisé**
**en ce que** le revêtement de plasma (14) est constitué d'un matériau ayant une propriété hydrophobe ou oléophobe.

4. Composite selon la revendication 3,
**caractérisé**
**en ce que** le matériau comprend au moins un éther, un cétone, un aldéhyde, un alcène, un alcyne, un amide, un nitrile, un thioéther, un ester d'acide carboxylique, un thioesther, un sulfone, un thiocétone, un thioaldéhyde, un sulfène, un sulfénamide, un fluoroacrylate, un siloxane, un époxide, un uréthane et/ou acrylate saturés, monoinsaturés et/ou polyinsaturés.

5. Composite selon une des revendications 1 à 4,
**caractérisé**
**en ce que** la membrane (12) est disposée entre deux couches de support (11, 15).

6. Procédé pour la fabrication d'un composite pour un composant acoustique selon une des revendications 1 à 5, selon lequel
- une couche de support (11, 15) est prévue et
- une membrane (12) est formée sur la couche de support (11, 15), la membrane (12) étant fabriquée selon un procédé d'électro-filage à partir de fibres superposées avec une structure poreuse définie,
- la couche de support (11, 15) et la membrane (12) étant reliées de façon fixe entre elles,
**caractérisé**
**en ce qu'**un tissu monofilament est prévu comme couche de support (11, 15) et
que le composite (10) est doté d'un revêtement superficiel (14) selon le procédé de revêtement plasma,
le revêtement de plasma (14) étant appliqué aussi bien sur la membrane électro-filée (12) que sur l'au moins une couche de support (11, 15).

7. Procédé pour la fabrication d'un composite selon la revendication 6, **caractérisé**
**en ce que** la membrane (12) est reliée de façon fixe avec la couche de support (11, 15) au moyen d'un procédé de fusion à chaud, en particulier au moyen d'un laser, par soudure par ultrasons, par laminage, par collage par traitement par plasma ou par une combinaison de ceux-ci.

8. Procédé selon une des revendications 6 ou 7,
**caractérisé**
**en ce que** la membrane électro-filée (12) est fabriquée directement sur la couche de support (11, 15), la membrane (12) étant reliée de façon fixe avec la couche de support (11, 15).

9. Procédé selon une des revendications 6 à 8,
**caractérisé**
**en ce qu'**il est prévu au moins une autre couche de support (11, 15) qui est également reliée avec la membrane (12), la membrane (12) étant disposée entre les couches de support (11, 15).
